# EUROPEAN PATENT APPLICATION

(11) **EP 4 687 402 A1**
(43) Date of publication of application: **04.02.2026**
(21) Application number: 25193519.3
(22) Date of filing: 01.08.2025
(51) Int. Cl.: H10H 29/02, H10W 80/00

(54) **TRANSFER DEVICE FOR LIGHT EMITTING ELEMENT AND METHOD USING THE SAME**

(30) Priority: 02.08.2024 KR 20240102855
(71) Applicant: Samsung Display Co., Ltd., Yongin-si, Gyeonggi-do 17113 (KR)
(72) Inventor: HAN, Jeong Won, Yongin-si, Gyeonggi-do (KR)
(74) Representative: Gulde & Partner

(57) **Abstract**

A transfer device (TDU) for a light emitting element (LE) includes a first transfer head (210), a second transfer head (220) disposed below the first transfer head (210), a stamp (230) disposed below the second transfer head (220), a tilting adjustment member configured to adjust a tilting of the second transfer head (220) and a buffer member (250, 250-1, 250-2) disposed below the second transfer head (220) to be adjacent to the stamp (230) and protruding in a downward direction to be lower than the stamp (230), where the buffer member (250, 250-1, 250-2) includes an elastic material, where a thickness of the buffer member (250, 250-1, 250-2) is greater than a sum of a thickness of the stamp (230) and a thickness of the light emitting element (LE).

## Description

### BACKGROUND

### 1. Field

Embodiments of the disclosure relate to a transfer device for a light emitting element and a method for transferring the light emitting elements using the transfer device.

### 2. Description of the Related Art

The importance of display devices is increasing along with the development of multimedia. Accordingly, various types of display devices such as organic light emitting display devices (OLED) and liquid crystal display devices (LCD), etc. are widely used in various fields.

A display panel such as a light emitting display panel or a liquid crystal display panel is typically included in an electronic device or a display device that displays an image. Among various types of the display panel, a light emitting display panel may include a light emitting diode (LED), and an organic LED that uses an organic substance as a fluorescent material or an inorganic LED that uses an inorganic substance as a fluorescent material may be used as the LED.

### SUMMARY

When manufacturing a display panel that uses an inorganic light emitting diode (LED) as an LED, a manufacturing device for arranging micro LEDs on a substrate of the display panel may be used.

Aspects and features of embodiments of the disclosure are to provide a transfer device for a light emitting element capable of effectively transferring the light emitting element and a transfer method using the transfer device.

According to an embodiment, a transfer device for a light emitting element includes a first transfer head, a second transfer head disposed below the first transfer head, a stamp disposed below the second transfer head, a tilting adjustment member which adjusts the tilting of the second transfer head and a buffer member disposed below the second transfer head to be adjacent to the stamp and protruding in a downward direction to be lower than the stamp, where the buffer member includes an elastic material, and a thickness of the buffer member is greater than a sum of a thickness of the stamp and a thickness of the light emitting element.

In an embodiment, the transfer device may further include a gas flow path disposed in the second transfer head to supply gas to the buffer member and a gas supply member which supplies gas to the buffer member through the gas flow path.

In an embodiment, the first transfer head may define a cavity with an opening in the downward direction, and a width of the opening may be smaller than a width of the cavity.

In an embodiment, the second transfer head may be divided into a first portion disposed in the cavity, a third portion disposed outside the first transfer head, and a second portion disposed between the first portion and the third portion, and a width of the second portion may be narrower than a width of the first portion and the third portion.

In an embodiment, the tilting adjustment member may include a first permanent magnet disposed on the first transfer head, a second permanent magnet disposed on the first portion of the second transfer head and facing the first permanent magnet and having a repulsive force with the first permanent magnet.

In an embodiment, the second transfer head may include a chuck on one side and may adsorb a stamp by the chuck.

In an embodiment, the second transfer head may be divided into a first portion disposed in the cavity, a third portion disposed outside the first transfer head, a second portion disposed between the first portion and the third portion, and an inclined portion disposed between the first portion and the second portion, and a width of the second portion may be narrower than a width of the first portion and the third portion.

In an embodiment, the tilting adjustment member may include a plurality of second permanent magnets disposed on the first portion and the inclined portion, and a plurality of first permanent magnets disposed on the first transfer head correspond to the plurality of second permanent magnets.

In an embodiment, the transfer device may further include a pressure member disposed between the first transfer head and the second transfer head within a cavity of the first transfer head, where the pressure member may press the second transfer head in the downward direction.

In an embodiment, the pressure member may include a spring.

In an embodiment, the pressure member may include an elastic film disposed on the second transfer head within the cavity of the first transfer head, a gas pipe connected between the elastic film and the cavity, and a gas supply member which supplies gas to the gas pipe.

In an embodiment, the first transfer head, the second transfer head, and the tilting adjustment member may collectively define an air gyro.

In an embodiment, the buffer members may be a plurality of buffer members disposed in a plurality of discontinuous manners around the stamp in a plan view.

In an embodiment, the plurality of buffer members may be disposed continuously around the stamp.

In an embodiment, the buffer member may include a diaphragm.

In an embodiment, the first transfer head may include a chuck disposed at a lower portion thereof, and the stamp may be adsorbed by the chuck.

According to an embodiment, a light emitting element transfer device includes the transfer device and may include at least one driving unit.

According to an embodiment, a method for transferring a light emitting element includes disposing a transfer device including a buffer member and a stamp on a substrate, lowering the transfer device to contact a lower surface of the buffer member with the substrate, where a thickness of the buffer member is thicker than a sum of a thickness of the stamp and a thickness of a light emitting element, the adjusting a flatness of the transfer device to a flatness of the substrate and the pressing the buffer member to contact and transfer the light emitting element with the substrate, wherein the buffer member is made of an elastic material, and the thickness of the buffer member becomes thinner when the buffer member is pressed.

In an embodiment, the disposing the transfer device on the substrate may include aligning the light emitting element disposed on the stamp with the substrate based on a first alignment mark disposed on one side of the stamp and a second alignment mark disposed on the substrate.

In an embodiment, the transfer device may include a first transfer head, a second transfer head disposed below the first transfer head, and a tilting adjustment member which adjusts a tilting of the second transfer head, and the adjusting the flatness of the transfer device to the flatness of the substrate may include adjusting the tilting of the second transfer head by the tilting adjustment member while the second transfer head is not in contact with the first transfer head.

In an embodiment, the transfer device may further include a gas supply member which supplies gas to the buffer member and a gas flow path connected between the gas supply member and the buffer member, and the method may further include supplying gas to the buffer member before the lowering the transfer device to contact a lower surface of the buffer member with the substrate.

According to embodiments of the method for manufacturing a display panel, a high-precision alignment may be performed by securing the relative flatness of the substrate while the light emitting element is not in contact with the substrate. Accordingly, the product quality of the display panel may be improved and the yield may be increased by reducing defects in the light emitting element, e.g., when transferring the light emitting element on a large-sized substrate.

However, the effects of embodiments of the disclosure are not limited to the aforementioned effects, and various other effects are included in the present specification.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other features of embodiments of the disclosure will become more apparent by describing in detail embodiments thereof with reference to the attached drawings, in which:
FIG. 1 is a plan view illustrating a display device according to an embodiment.
FIG. 2 is a plan view illustrating an example of a pixel of FIG. 1.
FIG. 3 is a plan view illustrating another example of a pixel of FIG. 1.
FIG. 4 is a cross-sectional view illustrating an example of a display panel taken along line A-A' of FIG. 2.
FIG. 5 is a schematic diagram schematically illustrating a light emitting element transfer device LTD according to an embodiment.
FIG. 6 is a schematic diagram schematically illustrating a transfer device TDU according to an embodiment.
FIGS. 7 to 10 are plan views to illustrate the number and shape of buffer members.
FIG. 8 is a cross-sectional view of a press member according to an embodiment.
FIG. 9 is a perspective view of a stamp assembly according to an embodiment.
FIG. 10 is a cross-sectional view of a stamp assembly according to an embodiment.
FIG. 11 is a drawing to illustrate the operation of a light emitting element transfer device LTD without a tilting adjustment member and a buffer member.
FIG. 12 is a schematic diagram schematically illustrating a transfer device TDU according to another embodiment.
FIG. 13 a schematic diagram schematically illustrating a transfer device TDU according to another embodiment.
FIG. 14 a schematic diagram schematically illustrating a transfer device TDU according to another embodiment.
FIG. 15 a schematic diagram schematically illustrating a transfer device TDU according to another embodiment.
FIG. 16 a schematic diagram schematically illustrating a transfer device TDU according to another embodiment.
FIG. 17 a schematic diagram schematically illustrating a transfer device TDU according to another embodiment.
FIG. 18 is a flow chart illustrating a light emitting element transfer method according to an embodiment.
FIGS. 19 to 23 are cross-sectional views illustrating an embodiment of a light emitting element transfer method.
FIG. 24 is a block diagram of an electronic device according to one embodiment of the present disclosure.
FIG. 25 is a schematic diagram of an electronic device according to various embodiments of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from " for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described in detail with reference to the accompanying drawings.

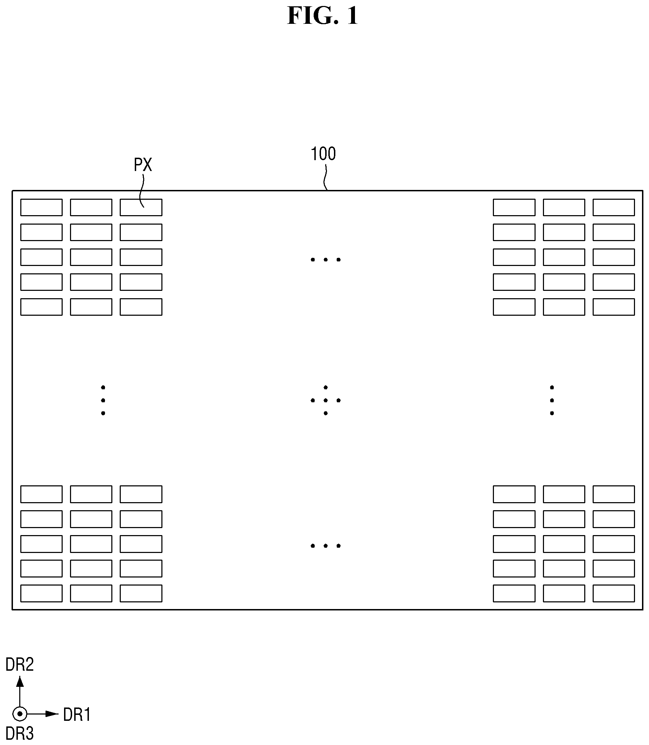

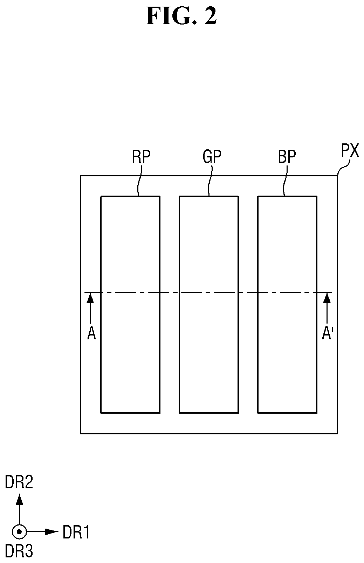

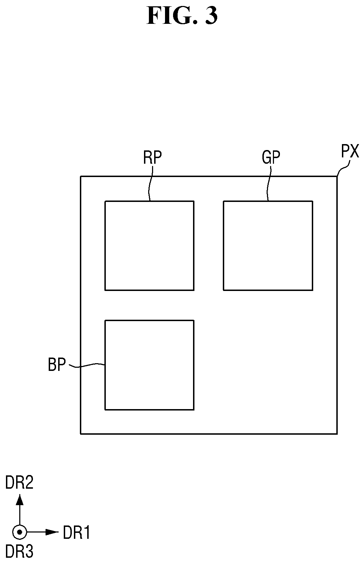

FIG. 1 is a plan view illustrating a display device according to an embodiment. FIG. 2 is a plan view illustrating an example of a pixel of FIG. 1. FIG. 3 is a plan view illustrating another example of a pixel of FIG. 1.

Referring to FIGS. 1 to 3, an embodiment of a display device 10 may be a device for displaying video or still images, such as mobile phones, smart phones, tablet personal computers, and portable electronic devices such as smart watches, watch phones, mobile communication terminals, electronic notebooks, e-books, portable electronic devices such as tablet personal computers (PCs), portable multimedia players (PMPs), navigation, and ultra mobile PCs (UMPCs), as well as may be used as display screens for a variety of products such as televisions, laptops, monitors, billboards, and the internet of things (IOT).

The display panel 100 may be formed in a rectangular planar shape having a long side in a first direction DR1 and a short side in a second direction DR2 intersecting the first direction DR1. A corner where the long side in the first direction DR1 and the short side in the second direction DR2 meet may be formed rounded to have a predetermined curvature or formed at a right angle. The planar shape of the display panel 100 is not limited to a rectangle, and may be formed in other polygonal, circular, or oval shapes. The display panel 100 may be formed flat but is not limited thereto. In an embodiment, for example, the display panel 100 is formed cured at left and right ends and may include curved portions with a constant curvature or a changing curvature. In an embodiment, the display panel 100 may be formed to be flexible, such as to be able to be bent, curved, bent, folded, or rolled.

The display panel 100 may further include pixels PX for displaying an image, scan lines extending in the first direction DR1, and data lines extending in the second direction DR2. The pixels PX may be disposed in a matrix form arranged in the first direction DR1 and the second direction DR2.

Each of the pixels PX may include a plurality of sub-pixels RP, GP, and BP as shown in FIGS. 2 and 3. In an embodiment, as shown in FIGS. 2 and 3, each of the pixels PX includes three sub-pixels RP, GP, and BP, that is, a first sub-pixel RP, a second sub-pixel GP, and a third sub-pixel BP, but the embodiment of the disclosure is not limited thereto.

Each of the first sub-pixel RP, the second sub-pixel GP, and the third sub-pixel BP may be connected to one of the data lines and at least one scan line among the scan lines.

Each of the first sub-pixel RP, the second sub-pixel GP, and the third sub-pixel BP may have a planar shape of a rectangle, a square, or a rhombus. In an embodiment, for example, each of the first sub-pixel RP, the second sub-pixel GP, and the third sub-pixel BP may have a planar shape of a rectangle having a short side in the first direction DR1 and a long side in the second direction DR2, as shown in FIG. 2. Alternatively, each of first sub-pixel RP, the second sub-pixel GP, and the third sub-pixel BP may have a planar shape of a square or a rhombus including sides having the same length in the first direction DR1 and the second direction DR2, as shown in FIG. 3.

In an embodiment, as shown in FIG. 2, the first sub-pixel RP, the second sub-pixel GP, and the third sub-pixel BP may be disposed in the first direction DR1. Alternatively, one of the second sub-pixel GP and the third sub-pixel BP and the first sub-pixel RP may be disposed in the first direction DR1, and the other one and the first sub-pixel RP may be disposed in the second direction DR2. In another embodiment, for example, as shown in FIG. 3, the first sub-pixel RP and the second sub-pixel GP may be disposed in the first direction DR1, and the first sub-pixel RP and the third sub-pixel BP may be disposed in the second direction DR2.

Alternatively, one of the first sub-pixel RP and the third sub-pixel BP and the second sub-pixel GP may be disposed in the first direction DR1, and the other one and the second sub-pixel GP may be disposed in the second direction DR2. Alternatively, one of the first sub-pixel RP and the second sub-pixel GP and the third sub-pixel BP may be disposed in the first direction DR1, and the remaining one and the third sub-pixel BP may be disposed in the second direction DR2.

The first sub-pixel RP may include a first light emitting element that emits first light, the second sub-pixel GP may include a second light emitting element that emits second light, and the third sub-pixel BP may include a third light emitting element that emits third light. Here, the first light may be light in a red wavelength band, the second light may be light in a green wavelength band, and the third light may be light in a blue wavelength band. The red wavelength band may be a wavelength band of about 600 nanometers (nm) to 750 nm, the green wavelength band may be a wavelength band of about 480 nm to 560 nm, and the blue wavelength band may be a wavelength band of about 370 nm to 460 nm, but the embodiments of the disclosure are not limited thereto.

Each of the first sub-pixel RP, the second sub-pixel GP, and the third sub-pixel BP may include an inorganic light emitting element having an inorganic semiconductor as a light emitting element that emits light. In an embodiment, for example, the inorganic light emitting element may be a micro light emitting diode (LED) of a flip-chip type, but the embodiment of the disclosure is not limited thereto.

In an embodiment, as shown in FIGS. 2 and 3, the area of the first sub-pixel RP, the area of the second sub-pixel GP, and the area of the third sub-pixel BP may be substantially the same as each other, but the embodiment of the disclosure is not limited thereto. At least one of the area of the first sub-pixel RP, the area of the second sub-pixel GP, and the area of the third sub-pixel BP may be different from another one thereof. Alternatively, any two of the area of the first sub-pixel RP, the area of the second sub-pixel GP, and the area of the third sub-pixel BP may be substantially the same as each other, and the remaining one thereof may be different from the two. Alternatively, the area of the first sub-pixel RP, the area of the second sub-pixel GP, and the area of the third sub-pixel BP may be different from each other.

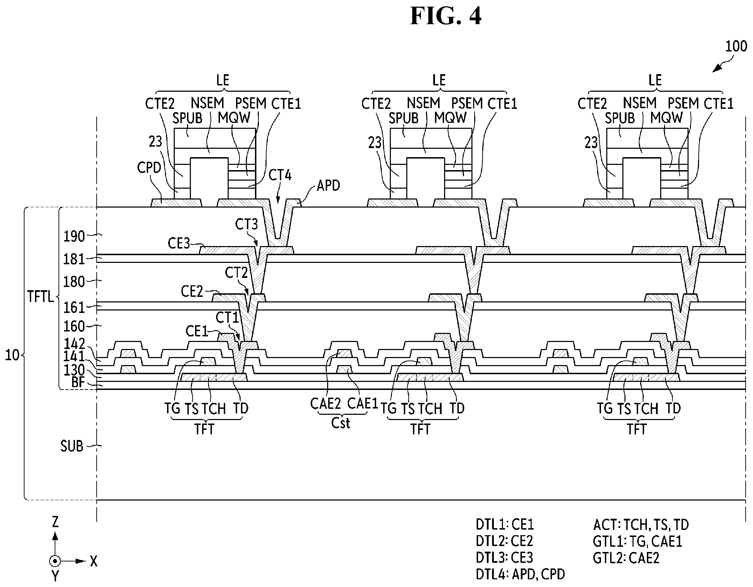

FIG. 4 is a cross-sectional view illustrating an example of a display panel taken along line A-A' of FIG. 2.

Referring to FIG. 4, the display panel 100 may include a thin film transistor layer TFTL and light emitting elements LE, which are disposed on a substrate SUB. The thin film transistor layer TFTL may be a layer on which thin film transistors TFT are disposed.

The thin film transistor layer TFTL may include an active layer ACT, a first gate layer GTL1, a second gate layer GTL2, a first data metal layer DTL1, a second data metal layer DTL2, a third data metal layer DTL3, and a fourth data metal layer DTL4. Further, the thin film transistor layer TFTL includes a buffer film BF, a gate insulating film 130, a first interlayer insulating film 141, a second interlayer insulating film 142, a first planarization film 160, a first insulating film 161, a second planarization film 180, and a second insulating film 181.

The substrate SUB may be a base substrate or a base member for supporting a display device. The substrate SUB may be a rigid substrate including or made of glass, but the embodiments of the disclosure are not limited thereto. The substrate SUB may be a flexible substrate capable of bending, folding, rolling, etc. In this case, the substrate SUB may include an insulating material such as a polymer resin such as polyimide (PI).

A buffer film BF may be disposed on one surface of the substrate SUB. The buffer film BF may be a film for preventing the penetration of air or moisture. The buffer film BF may be defined by or formed of a plurality of inorganic films alternately laminated. In an embodiment, for example, the buffer film BF may be formed as a multilayer of alternately stacked inorganic films including one or more of a silicon nitride layer, a silicon oxynitride layer, a silicon oxide layer, a titanium oxide layer, and an aluminum oxide layer. In another embodiment, the buffer film BF may be omitted.

An active layer ACT may be disposed on the buffer film BF. The active layer ACT may include a silicon semiconductor, such as polycrystalline silicon, monocrystalline silicon, low-temperature polycrystalline silicon, and amorphous silicon, or may include an oxide semiconductor.

The active layer ACT may include a channel TCH, a first electrode TS, and a second electrode TD of a thin film transistor TFT. The channel TCH of the thin film transistor TFT may be an area overlapping a gate electrode TG of the thin film transistor TFT in the third direction DR3 that is a thickness direction of the substrate SUB. The first electrode TS of the thin film transistor TFT may be disposed on one side of the channel TCH, and the second electrode TD may be disposed on the other side of the channel TCH. The first electrode TS and the second electrode TD of the thin film transistor TFT may be areas that do not overlap the gate electrode TG in the third direction DR3. The first electrode TS and the second electrode TD of the thin film transistor TFT may be areas in which ions are doped in a silicon semiconductor or an oxide semiconductor to have conductivity.

A gate insulating film 130 may be disposed on the active layer ACT. The gate insulating film 130 may include or be formed of an inorganic film, such as a silicon nitride layer, a silicon oxynitride layer, a silicon oxide layer, a titanium oxide layer, or an aluminum oxide layer.

A first gate layer GTL1 may be disposed on the gate insulating film 130. The first gate layer GTL1 may include the gate electrode TG of the thin film transistor TFT and the first capacitor electrode CAE1. The first gate layer GTL1 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

A first interlayer insulating film 141 may be disposed on the first gate layer GTL1. The first interlayer insulating film 141 may include or be formed of an inorganic film, such as a silicon nitride layer, a silicon oxynitride layer, a silicon oxide layer, a titanium oxide layer, or an aluminum oxide layer.

A second gate layer GTL2 may be disposed on the first interlayer insulating film 141. The second gate layer GTL2 may include a second capacitor electrode CAE2. The second gate layer GTL2 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

A second interlayer insulating film 142 may be disposed on the second gate layer GTL2. The second interlayer insulating film 142 may include or be formed of an inorganic film, such as a silicon nitride layer, a silicon oxynitride layer, a silicon oxide layer, a titanium oxide layer, or an aluminum oxide layer.

A first data metal layer DTL1 including a first connection electrode CE1, a first sub-pad SPD1, and a data line DL may be disposed on the second interlayer insulating film 142. The data line DL may be formed integrally with the first sub-pad SPD1, but the embodiment of the disclosure is not limited thereto. The first data metal layer DTL1 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

A first connection electrode CE1 may be connected to the first electrode TS or the second electrode TD of the thin film transistor TFT through the first contact hole CT1 defined or formed in the first interlayer insulating film 141 and the second interlayer insulating film 142.

A first planarization film 160 may be disposed on the first data metal layer DTL1 to planarize a step (or a stepped structure) caused by the active layer ACT, the first gate layer GTL1, the second gate layer GTL2, and the first data metal layer DTL1. The first planarization film 160 may include or be formed from an organic film such as an acrylic resin, an epoxy resin, a phenolic resin, a polyamide resin, a polyimide resin, or the like.

A second data metal layer DTL2 may be disposed on the first planarization film 160. The second data metal layer DTL2 may include a second connection electrode CE2 and a second sub pad PD2. The second connection electrode CE2 may be connected to the first connection electrode CE1 through a second contact hole CT2 defined or formed in the first insulating film 161 and the first planarization film 160. The second data metal layer DTL2 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second data metal layer DTL2. The second planarization film 180 may be formed of an organic film, such as an acrylic resin, an epoxy resin, a phenolic resin, a polyamide resin, a polyimide resin, or the like.

A third data metal layer DTL3 may be disposed on the second planarization film 180. The third data metal layer DTL3 may include a third connection electrode CE3 and a third sub pad SPD3. The third connection electrode CE3 may be connected to the second connection electrode CE2 through a third contact hole CT3 penetrating the second insulating film 181 and the second planarization film 180. The third data metal layer DTL3 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

A third planarization film 190 may be disposed on the third data metal layer DTL3. The third planarization film 190 may include or be formed of an organic film, such as an acrylic resin, an epoxy resin, a phenolic resin, a polyamide resin, a polyimide resin, or the like.

A fourth data metal layer DTL4 may be disposed on the third planarization film 190. The fourth data metal layer DTL4 may include an anode pad electrode APD, a cathode pad electrode CPD, and a fourth sub pad SPD. The anode pad electrode APD may be connected to a third connection electrode CE3 through a fourth contact hole CT4 defined or formed in the third insulating film 191 and the third planarization film 190. The cathode pad electrode CPD may be supplied with a first power supply voltage that is a low potential voltage. The fourth data metal layer DTL4 may be formed as a single layer or multiple layers, each layer therein including at least one selected from molybdenum (Mo), aluminum (Al), chromium (Cr), gold (Au), titanium (Ti), nickel (Ni), neodymium (Nd), and copper (Cu), or an alloy thereof.

The light emitting element LE is exemplified as a flip-chip type micro LED in which the first contact electrode CTE1 and the second contact electrode CTE2 are disposed to face the anode pad electrode APD and the cathode pad electrode CPD but is not limited thereto. The light emitting element LE may be an inorganic light emitting element including or made of an inorganic material such as GaN. The light emitting element LE may have a length in the first direction DR1, a length in the second direction DR2, and a length in the third direction DR3 of several to several hundred micrometers (µm), respectively. In an embodiment, for example, the light emitting element LE may have a length in the first direction DR1, a length in the second direction DR2, and a length in the third direction DR3 of approximately 100 µm or less, respectively.

In an embodiment, the light emitting elements LE may be grown and formed on a semiconductor substrate such as a silicon wafer. Each of the light emitting elements LE may be transferred directly from the silicon wafer onto the anode pad electrode APD and the cathode pad electrode CPD of the substrate SUB. In such an embodiment, the first contact electrode CTE1 and the anode pad electrode APD may be bonded to each other through a bonding process. Further, the second contact electrode CTE2 and the cathode pad electrode CPD may be bonded to each other through the bonding process. The first contact electrode CTE1 and the anode pad electrode APD may be electrically connected to each other through a bonding electrode 23. Furthermore, the second contact electrode CTE2 and the cathode pad electrode CPD may be electrically connected to each other through the bonding electrode 23.

In an embodiment, for example, the bonding electrode 23 may be disposed on one side of the light emitting element LE. The bonding electrode 23 may be a bonding product for pressurized melting bonding using a laser. Here, the pressurized melting bonding refers to a state in which the bonding electrode 23 is heated and melted, and the light emitting element LE, the anode pad electrode APD, and the cathode pad electrode CPD are melted and mixed, and then cooled and solidified when the laser supply is terminated. Since the conductivity of the light emitting element LE, the anode pad electrode APD, and the cathode pad electrode CPD is maintained while being cooled and solidified in a melted and mixed state, the anode pad electrode APD, the cathode pad electrode CPD, and the light emitting element LE may be electrically connected and physically connected to each other, respectively. Accordingly, the bonding electrode 23 may be disposed on the first contact electrode CTE1 and the second contact electrode CTE2 of the light emitting element LE.

The bonding electrode 23 may include, for example, Au, AuSn, PdIn, InSn, NiSn, Au-Au, AgIn, AgSn, Al, Ag, or carbon nanotubes CNT. Each of these may be used alone or in combination of two or more.

Each of the light emitting elements LE may be a light emitting structure including a base substrate SPUB, an n-type semiconductor NSEM, an active layer MQW, a p-type semiconductor PSEM, a first contact electrode CTE1, and a second contact electrode CTE2.

The base substrate SPUB may be a sapphire substrate, but the embodiments of the disclosure are not limited thereto.

The n-type semiconductor NSEM may be disposed on one surface of the base substrate SPUB. In an embodiment, for example, the n-type semiconductor NSEM may be disposed on a bottom surface of the base substrate SPUB. The n-type semiconductor NSEM may include or be made of GaN doped with n-type conductive dopants such as Si, Ge, Sn, or the like.

The active layer MQW may be disposed on a portion of one surface of the n-type semiconductor NSEM. The active layer MQW may include a material having a single or multiple quantum well structure. In an embodiment where the active layer MQW includes a material having a multi-quantum well structure, it may have a structure in which multiple well layers and barrier layers are alternately laminated. In this case, the well layers may be formed of InGaN, and the barrier layers may be formed of GaN or AlGaN but are not limited thereto. Alternatively, the active layer MQW may have a structure in which semiconductor materials having a large band gap energy and semiconductor materials having a small band gap energy are alternately laminated and may include different group III to group V semiconductor materials depending on the wavelength of the light emitted.

In an embodiment of the disclosure, a flip-chip type light emitting element has been described as an example, but it is not limited thereto and a vertical type light emitting element may be used.

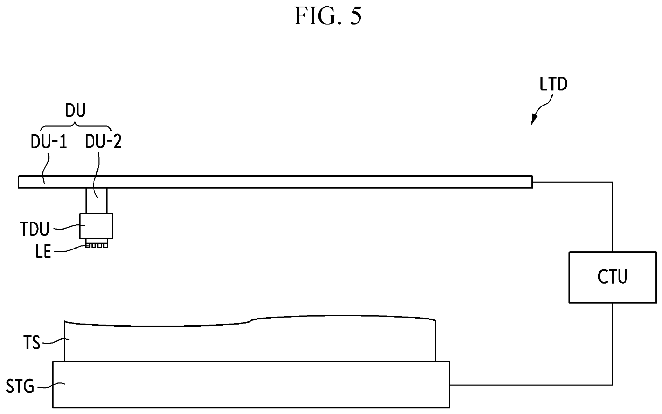

FIG. 5 is a schematic diagram schematically illustrating a light emitting element transfer device LTD according to an embodiment.

The light emitting element transfer device LTD according to an embodiment is a device used to transfer a light emitting element.

As shown in FIG. 5, an embodiment of the light emitting element transfer device LTD includes a driving unit DU, a transfer device TDU, a stage STG, and a controller CTU.

The driving unit DU enables the transfer device TDU to move up, down, left, and right. The driving unit DU may include an XY driving unit DU-1 and a Z driving unit DU-2.

The XY driving unit DU-1 moves the transfer device TDU above the stage STG on which the light emitting element LE is placed.

The Z driving unit DU-2 lowers the transfer device TDU to approach a predetermined distance from the light emitting element LE to be picked up.

The transfer device TDU is a device for picking up the light emitting element LE.

The transfer device TDU may include, for example, one of an electrostatic chuck, an adhesive chuck, a vacuum chuck, or a porous vacuum chuck. The transfer device TDU may lift the light emitting element LE by sucking the light emitting element LE using the chuck. In FIG. 5, an embodiment where the transfer device TDU is used for transferring the light emitting element LE to the substrate TS is shown, but it is not limited thereto, and the transfer device TDU may be applied to soy flip chip mounting in which a flip chip is connected to a bump arranged in an array shape on the substrate TS, and may also be applied to so-called die bonding in which the light emitting element LE is bonded to the substrate TS.

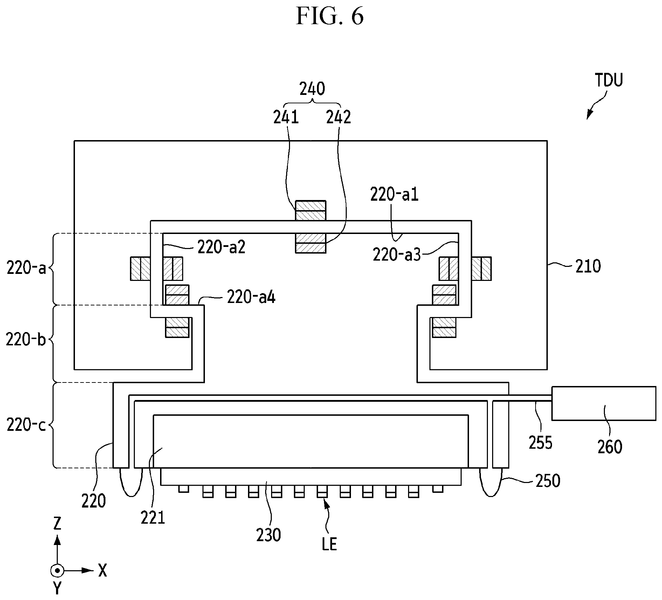

The structure of the transfer device TDU will be described later in greater detail with reference to FIG. 6.

In an embodiment, as shown in FIG. 5, the stage STG supports the substrate TS. The stage STG may be installed at the center of the XY driving unit DU-1. In an embodiment, the stage STG may be installed to be movable in the Y direction but is not limited thereto.

The controller CTU is connected to the driving unit DU and the transfer device TDU and is configured to perform processing for transfer by controlling the operation of these components by the controller CTU. The controller CTU is provided with an interface (not shown) that transmits and receives signals between the above-described components, such as the driving unit DU and the transfer device TDU, for example. The controller CTU is configured to feed back the processing for the above-described bonding based on the detection result of a camera or sensor, etc. In an embodiment, for example, the controller CTU recognizes a marker on the light emitting element LE substrate TS based on an image taken by a camera, detects a position, and controls the XY driving unit DU-1 and the Z driving unit DU-2 based on the detection result to perform control related to a transfer operation of aligning the position of the light emitting element LE.

Next, the configuration of an embodiment of the transfer device TDU will be described.

FIG. 6 is a schematic diagram schematically illustrating a transfer device TDU according to an embodiment.

Referring to FIG. 6, an embodiment of the transfer device TDU may include a first transfer head 210, a second transfer head 220, a stamp 230, a tilting adjustment member 240, and a buffer member 250.

The first transfer head 210 is connected to the Z driving unit DU-2 and is configured to support the second transfer head 220.

The first transfer head 210 defines a cavity with an opening in a downward direction. The width of the opening may be smaller than the width of the cavity.

The second transfer head 220 may be disposed below the first transfer head 210.

The second transfer head 220 may be divided into a first portion 220-a, a second portion 220-b, and a third portion 220-c. The first portion 220-a is disposed within the cavity of the first transfer head 210, the third portion 220-c is disposed outside the first transfer head 210, and the second portion 220-b is disposed between the first portion 220-a and the second portion 220-c.

The second portion 220-b may be formed with a narrower width than the first portion 220-a and the third portion 220-c, such that the first portion 220-a may be formed to be inserted in the cavity of the first transfer head 210. The first portion 220-a may have a shape that correspond to the shape of the cavity of the first transfer head 210.

The second transfer head 220 may include a chuck 221 on one side, and the chuck 221 is one of an electrostatic chuck, a tacky chuck, a vacuum chuck, or a porous vacuum chuck. In an embodiment, for example, the chuck 221 may be disposed on one side of the third portion 220-c. The stamp 230 may be adsorbed on one side of the second transfer head 220 by the chuck 221.

The stamp 230 may be disposed on a lower portion of the second transfer head 220.

The stamp 230 may include a plurality of layers. In an embodiment, for example, the stamp 230 may include a base layer and a stamp layer.

The base layer may support the stamp layer. The base layer may include or be made of, for example, polyethylene terephthalate (PET), polyurethane (PU), polyimide (PI), polycarbonate (PC), polyethylene (PE), polypropylene (PP), polysulfone (PSF), polymethylmethacrylate (PMMA), triacetylcellulose (TAC), cycloolefin polymer (COP), or the like.

The stamp layer is disposed on one side of the base layer. The stamp layer includes a plurality of protrusions and may adhere or bond the light emitting element LE thereto. The stamp layer may include or be made of an adhesive or an adhesive material, and the adhesive may include, for example, an optical clear adhesive (OCA), a pressure sensitive adhesive (PSA), or the like, and the adhesive material may include, for example, an acrylic-based, urethane-based, or silicone-based adhesive material. In an embodiment, one end of the plurality of protrusions is flat, and the shape of the protrusions may be a polygonal column or a cylinder.

The tilting adjustment member 240 may adjust the relative flatness between the stamp 230 and the substrate TS by adjusting the tilting of the second transfer head 220.

The tilting adjustment member 240 may include a plurality of permanent magnets. The tilting adjustment member 240 may include a plurality of first permanent magnets 241 and a plurality of second permanent magnets 242. The plurality of first permanent magnets 241 may be attached to the first transfer head 210. The plurality of second permanent magnets 242 may be attached to the second transfer head 220. In an embodiment, for example, the plurality of first permanent magnets 241 may be attached to the cavity of the first transfer head 210, that is, inner surface of the first transfer head 210 defining the cavity, and the plurality of second permanent magnets 242 may be attached to a first side 220-a1, a second side 220-a2, a third side 220-a3, and a fourth side 220-a4 of the first portion 220-a of the second transfer head 220. The number of first permanent magnets 241 and the number of second permanent magnets 242 are the same as each other.

The first permanent magnets 241 and the second permanent magnets 242 are disposed facing each other, and polarities of the first permanent magnets 241 and the second permanent magnets 242 facing each other are the same as each other. In an embodiment, for example, the S-polar magnetic pole of the first permanent magnet 241 and the S-polar magnetic pole of the second permanent magnet 242 face each other. The repulsive forces between the facing magnetic poles of the first permanent magnet 241 and the second permanent magnet 242 are balanced, such that the first permanent magnet 241 and the second permanent magnet 242 do not touch each other and the second transfer head 220 floats in the cavity.

In an embodiment, as shown in FIG. 6, a total of five pairs of the first permanent magnet 241 and the second permanent magnet 242 may be provided, but the number or positions of the first permanent magnet 241 and the second permanent magnet 242 is not limited thereto.

In an embodiment, the magnetic force between the first permanent magnet 241 and the second permanent magnet 242 serves to return the second transfer head 220 to its original position when the external force is removed, even if the second transfer head 220 is tilted by an external force.

In such an embodiment, since the second transfer head 220 floats due to the repulsive force of the first permanent magnet 241 and the second permanent magnet 242, the first transfer head 210 may not tilt even if the second transfer head 220 tilts. In such an embodiment, the second transfer head 220 may tilt depending on the flatness of the substrate disposed underneath.

The buffer member 250 may be disposed around the stamp 230 on one side of the second transfer head 220. The buffer member 250 may protrude lower than the stamp 230. That is, a lower end of the buffer member 250 is positioned lower than a lower end of the stamp 230. In an embodiment, for example, the thickness of the buffer member 250 may be thicker than the sum of the thickness of the stamp 230 and the thickness of the light emitting element LE. As a result, when the second transfer head 220 descends, the buffer member 250 may first contact the upper surface of the substrate TS.

The buffer member 250 may include or be composed of a material that may be elastically deformed. In an embodiment, for example, the buffer member 250 may be formed of a silicone multi-layer, a silicone-PET (polyethylene terephthalate) laminated layer, or the like. However, it is not limited thereto. In an embodiment, for example, the buffer member 250 may be a diaphragm.

The transfer device TDU may further include a gas flow path 255 and a gas supply member 260.

The gas flow path 255 is a path for supplying gas to the buffer member 250 and may be disposed or defined in the second transfer head 220.

The gas supply member 260 may supply gas to the buffer member 250 through the gas flow path 255 to expand the buffer member 250.

The gas supply member 260 may supply an inert or extremely low chemically reactive gas, such as nitrogen (N₂), helium (He), neon (Ne), argon (Ar), carbon dioxide (CO₂), or a mixture thereof, to the internal space. Hereinafter, such inert or extremely low chemically reactive gases are collectively referred to as neutral gas.

The gas supply member 260 may include a reservoir for storing gas, a gas pump for pressurizing and supplying the gas, a gas valve for controlling the flow of the gas, etc. Also, the gas supply member 260 may discharge gas that has expanded the buffer member 250 through the gas flow path 255.

The gas valve may be closed such that the supply of the gas is stopped and the internal pressure of the buffer member 250 is maintained when the pressure inside the buffer member 250 is sufficiently high. The gas valve may be, for example, a ball valve, a globe valve, a gate valve, a control valve, or the like., and is not particularly limited.

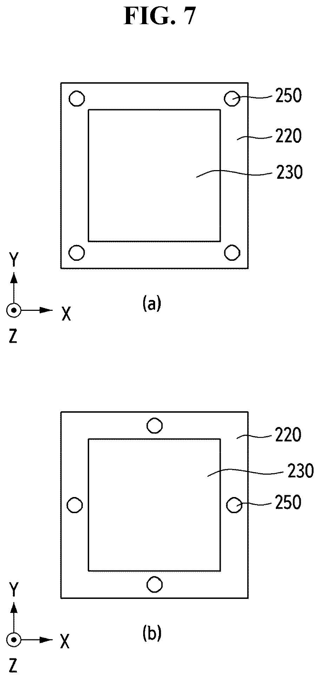

FIGS. 7 to 10 are plan views to illustrate the number and shape of buffer members.

Referring to FIGS. 7 to 10, in embodiments, the number and shape of the buffer members may be modified in various ways.

Referring to FIGS. 7 to 10, the stamp 230 may have a shape (planar shape) corresponding to the shape of the second transfer head 220. In an embodiment, for example, where the second transfer head 220 has a square shape, the shape of the stamp 230 may also be square, but is not limited thereto. In an embodiment, for example, the second transfer head 220 and the stamp 230 may have a circular shape in a plan view.

The buffer member 250 may be disposed around the stamp 230 on one side of the second transfer head 220 in a plan view. The buffer member 250 does not overlap the stamp 230 in a plan view.

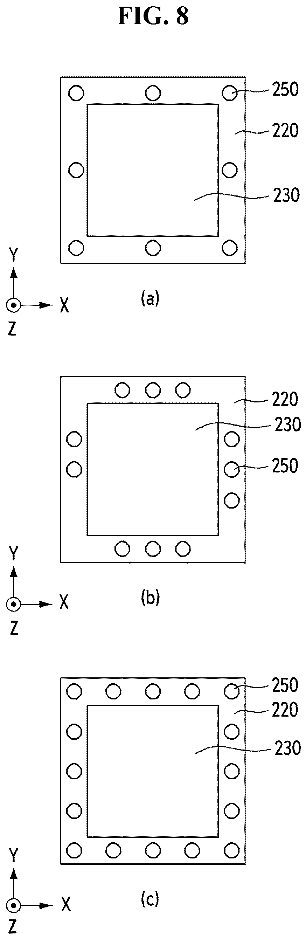

Referring to FIGS. 7 and 8, a plurality of buffer members 250 may be circular in a plan view.

In an embodiment, for example, referring to FIG. 7 (a), the plurality of buffer members 250 may be respectively disposed at the four corners of the second transfer head 220.

In another embodiment, referring to FIG. 7 (b), the plurality of buffer members 250 may be respectively disposed at the center of each side of the second transfer head 220.

In another embodiment, referring to FIG. 8 (a), the plurality of buffer members 250 may be respectively disposed at the four corners and the center of each side of the second transfer head 220.

In another embodiment, referring to FIG. 8 (b), the plurality of buffer members 250 may be respectively disposed at each side of the second transfer head 220 except for the four corners of the second transfer head 220. In an embodiment, for example, three buffer members 250 may be arranged at each side.

In another embodiment, referring to FIG. 8 (c), the plurality of buffer members 250 may be disposed at the four corners of the second transfer head 220 and each side of the second transfer head 220. Each of the buffer members 250 may be disposed at equal intervals from each other but is not limited thereto.

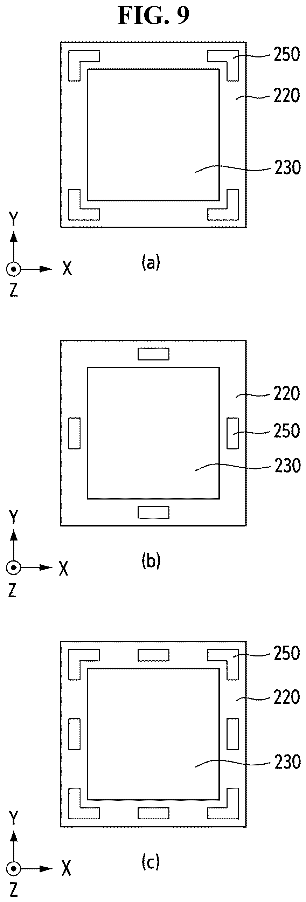

Referring to FIG. 9, the plurality of buffer members 250 may be polygons having corners in a plan view.

Referring to FIG. 9 (a), in an embodiment, the plurality of buffer members 250 may be disposed to surround the corners of the stamp 230 at the four corners of the second transfer head 220. In an embodiment, for example, the buffer members 250 may be in the shape of the letter " 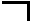 " or " 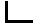 ".

Referring to FIG. 9 (b), in another embodiment, the plurality of buffer members 250 may be disposed at the center of each side of the second transfer head 220 in a square shape.

Referring to FIG. 9 (c), in another embodiment, the plurality of buffer members 250 may have different shapes. In an embodiment, for example, the plurality of buffer members 250 may be disposed to surround the corners of the stamp 230 at the four corners of the second transfer head 220, and may further be disposed at the center of each of the square sides of the second transfer head 220.

Referring to FIGS. 7 to FIG. 9, the buffer members 250 may be disposed discontinuously around the stamp 230.

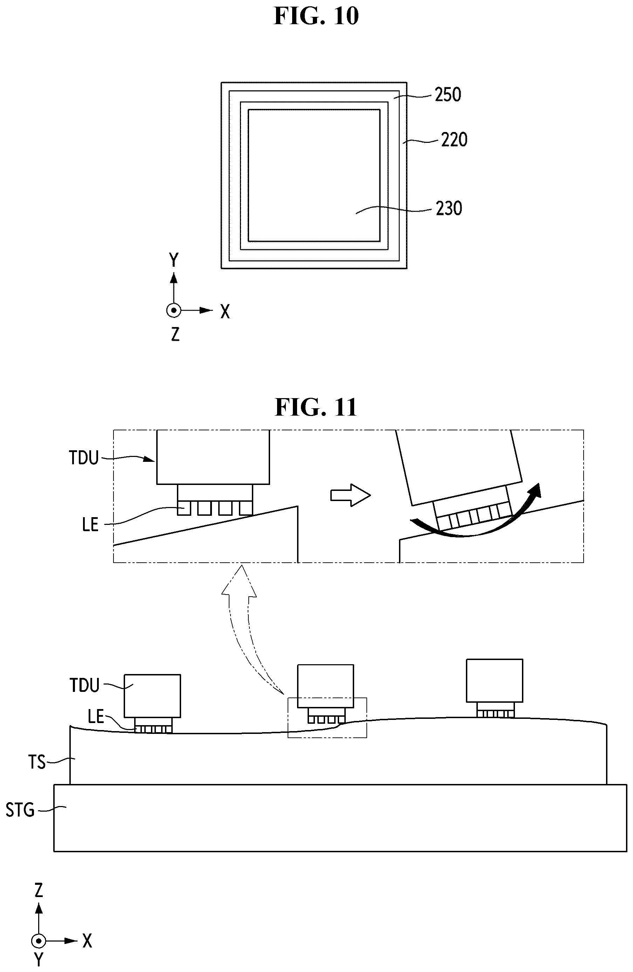

Referring to FIG. 10, the buffer members 250 may be disposed continuously around the stamp 230 in a plan view. In an embodiment, for example, the buffer members 250 may be in the shape of a single square surrounding the stamp 230 at the second transfer head 220.

Referring to FIGS. 7 to FIG. 10, in embodiments, the number and shape of the buffer members may be variously modified.

FIG. 11 is a drawing to illustrate the operation of a light emitting element transfer device LTD without a tilting adjustment member and a buffer member.

In a conventional light emitting element transfer device that does not include a tilting adjustment member (240 of FIG. 6) and the buffer member (250 of FIG. 6), the light emitting elements LE attached to the stamp 230 may rotate after the surface of the substrate TS is touched by the bending or tilting of the substrate TS. Accordingly, a change in the plane direction position may occur due to the rotation of the stamp 230. Accordingly, the light emitting element LE that first touches the surface of the substrate TS falls over or becomes misaligned due to a force applied in the plane direction on the surface of the substrate TS. In this case, since the bending or tilting of the substrate TS occurs frequently, especially in the case of a large-sized substrate TS, the above-mentioned problem may occur more extensively.

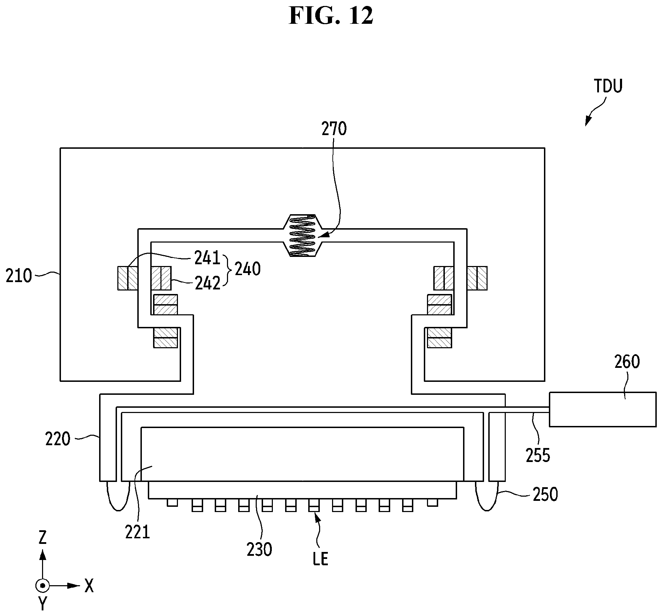

FIG. 12 is a schematic diagram schematically illustrating a transfer device TDU according to another embodiment.

The transfer device TDU shown in FIG. 12 is substantially the same as the transfer device TDU shown in FIG. 6 except that the transfer device TDU includes a pressure member 270 between the first transfer head 210 and the second transfer head 220. The description described above in FIG. 6 may be applied equally to the configuration other than the pressure member 270, and the following description will focus on the pressure member 270.

In an embodiment, the pressure member 270 is disposed in the cavity of the first transfer head 210 and is disposed between the first transfer head 210 and the second transfer head 220, such that the second transfer head 220 may be pressurized while maintaining the space between the first transfer head 210 and the second transfer head 220.

In such an embodiment, the pressure member 270 may include, for example, a spring, but is not limited thereto. In an embodiment where the pressure member 270 is formed as a spring, where the pressure member 270 may effectively prevent a sudden transfer of pressure when applying a pressure force from the top to the bottom of the first transfer head 210.

In an embodiment, as shown in FIG. 12, a single pressure member 270 may be disposed between the first transfer head 210 and the second transfer head 220, but the number of pressure members 270 is not limited. In another embodiment, for example, a plurality of springs may be disposed between the first transfer head 210 and the second transfer head 220.

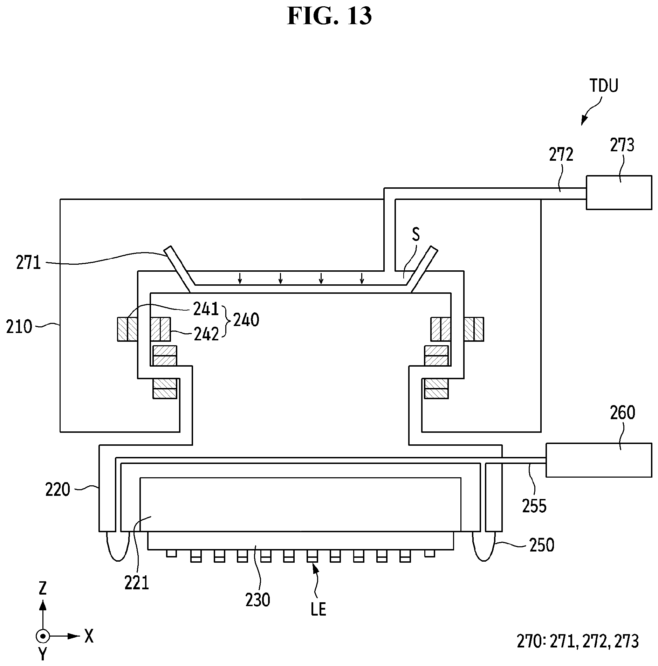

FIG. 13 a schematic diagram schematically illustrating a transfer device TDU according to another embodiment.

The transfer device TDU shown in FIG. 13 is substantially the same as the transfer device TDU shown in FIG. 6 except that the transfer device TDU includes a pressure member 270 between the first transfer head 210 and the second transfer head 220. The description described above in FIG. 6 may be applied equally to the configuration other than the pressure member 270, and the following description will focus on the pressure member 270.

In an embodiment, the pressure member 270 is disposed in a cavity of the first transfer head 210 and is disposed between the first transfer head 210 and the second transfer head 220, such that a space between the first transfer head 210 and the second transfer head 220 may be maintained.

In an embodiment, the pressure member 270 may be a member for preventing sudden transfer of pressure when applying a pressure force from the top to the bottom direction of the first transfer head 210. The pressure member 270 may include, for example, a spring, but is not limited thereto.

In an embodiment, as shown in FIG. 13, the pressure member 270 may include an elastic film 271, a gas pipe 272, and a gas supply member 273.

The elastic film 271 may include or be formed of an elastic material such as an elastomer.

A space S may be provided or defined between the elastic film 271 and the first transfer head 210.

The gas pipe 272 may supply gas to the space S between the elastic film 271 and the first transfer head 210 to expand the elastic film 271 downward. When the elastic film 271 expands, the second transfer head 220 is pressurized.

The gas supply member 273 supplies gas to the space S through the gas pipe 272. The gas supply member 273 controls the expansion force of the elastic film 271, thereby effectively controlling the pressurizing force to the second transfer head 220.

The gas supply member 273 may supply an inert or extremely low chemically reactive gas, such as nitrogen (N₂), helium (He), neon (Ne), argon (Ar), carbon dioxide (CO₂), or a mixture thereof, to the internal space. Hereinafter, such inert or extremely low chemically reactive gases are collectively referred to as neutral gas.

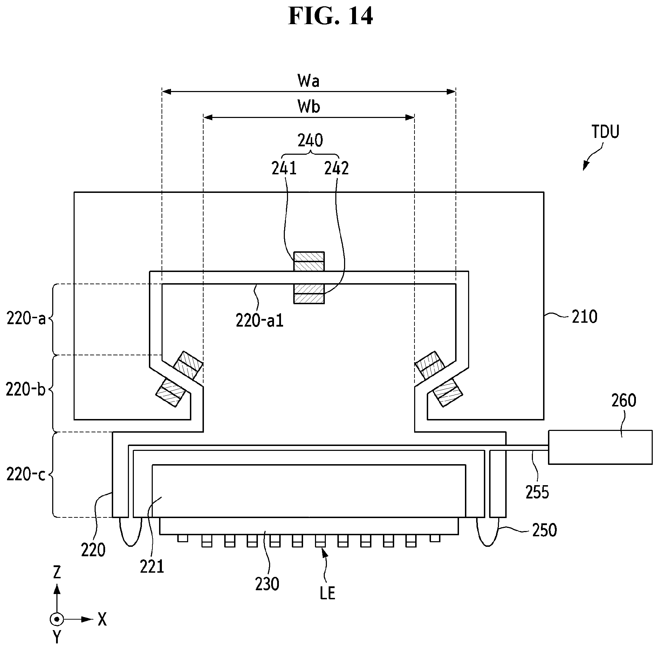

FIG. 14 a schematic diagram schematically illustrating a transfer device TDU according to another embodiment.

The transfer device TDU shown in FIG. 14 is substantially the same as the transfer device TDU shown in FIG. 6 except that the transfer device TDU further includes an inclined portion 220-ab between the first portion 220-a and the second portion 220-b, and a relatively smaller number of tilting adjustment members 240 is provided.

In an embodiment, the inclined portion 220-ab is disposed between the first portion 220-a having a first width Wa and the second portion 220-b having a second width Wb and connects one end of the first portion 220-a and one end of the second portion 220-b, and has an inclination angle with a side parallel to the first side 220-a1 of the first portion 220-a, that is, has an inclination surface which is inclined with the side parallel to the first side 220-a1 of the first portion 220-a.

The tilting adjustment member 240 may be disposed on the first surface 220-a1 and the inclined portion 220-ab of the second transfer head 220 and may include a total of three pairs of first permanent magnets 241 and a plurality of second permanent magnets 242.

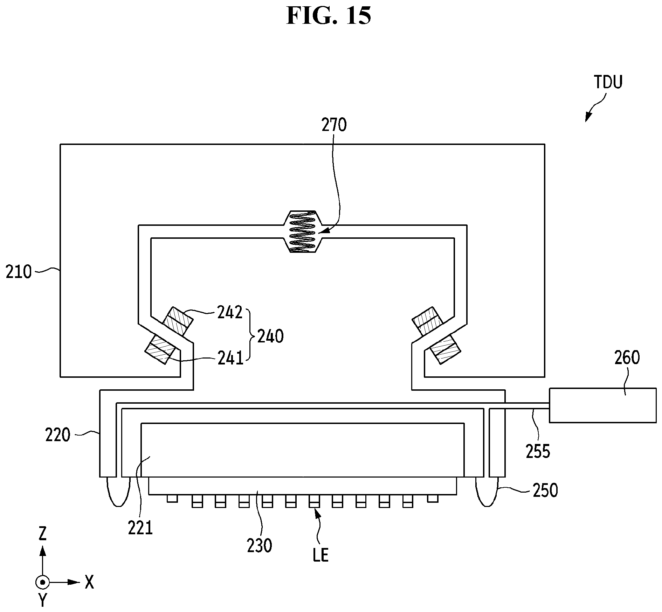

FIG. 15 a schematic diagram schematically illustrating a transfer device TDU according to another embodiment.

The transfer device TDU shown in FIG. 15 is substantially the same as the transfer device TDU shown in FIG. 14 except that the transfer device TDU includes a pressure member 270 between the first transfer head 210 and the second transfer head 220. The description described above in FIG. 14 may be applied equally to the configuration other than the pressure member 270, and the following description will focus on the pressure member 270.

In an embodiment, the pressure member 270 is disposed in the first transfer head 210 and is disposed between the first transfer head 210 and the second transfer head 220, so that the second transfer head 220 may be pressurized while maintaining the space between the first transfer head 210 and the second transfer head 220.

In an embodiment, the pressure member 270 may include, for example, a spring, but is not limited thereto. In such an embodiment where the pressure member 270 is formed as a spring, the pressure member 270 may effectively prevent a sudden transfer of pressure when applying a pressure force from the top to the bottom of the first transfer head 210.

In an embodiment, a single pressure member 270 is disposed between the first transfer head 210 and the second transfer head 220 as shown in FIG. 15, but the number of pressure members 270 is not limited.

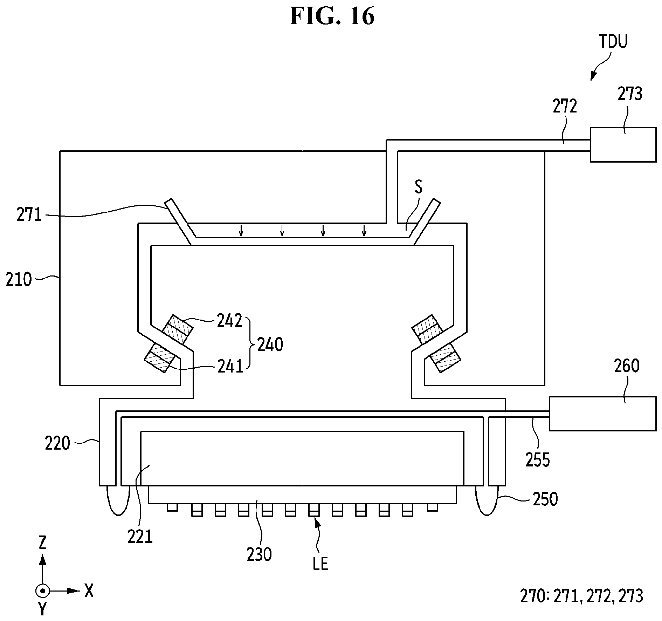

FIG. 16 a schematic diagram schematically illustrating a transfer device TDU according to another embodiment.

The transfer device TDU shown in FIG. 16 is substantially the same as the transfer device TDU shown in FIG. 14 in that the transfer device TDU includes a pressure member 270 between the first transfer head 210 and the second transfer head 220. The description described above in FIG. 14 may be applied equally to the configuration other than the pressure member 270, and the following description will focus on the pressure member 270.

In an embodiment, the pressure member 270 is disposed in the cavity of the first transfer head 210 and is disposed between the first transfer head 210 and the second transfer head 220, such that a space between the first transfer head 210 and the second transfer head 220 may be maintained.

In an embodiment, the pressure member 270 may be a member for preventing sudden transfer of pressure when applying a pressure force from the top to the bottom direction of the first transfer head 210. The pressure member 270 may include, for example, a spring, but is not limited thereto.

In an embodiment, as shown in FIG. 16, the pressure member 270 may include an elastic film 271, a gas pipe 272, and a gas supply member 273.

The elastic film 271 may include or be formed of an elastic material such as an elastomer.

A space S may be provided or defined between the elastic film 271 and the first transfer head 210.

The gas pipe 272 may supply gas to the space S between the elastic film 271 and the first transfer head 210 to expand the elastic film 271 downward. When the elastic film 271 expands, the second transfer head 220 is pressurized.

The gas supply member 273 supplies gas to the space S through the gas pipe 272.

The gas supply member 273 may supply an inert or extremely low chemically reactive gas, such as nitrogen (N₂), helium (He), neon (Ne), argon (Ar), carbon dioxide (CO₂), or a mixture thereof, to the internal space. Hereinafter, such inert or extremely low chemically reactive gases are collectively referred to as neutral gas.

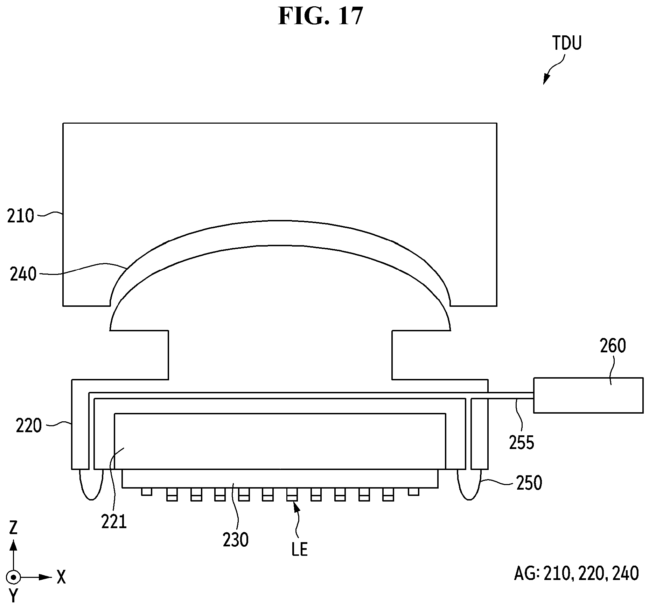

FIG. 17 a schematic diagram schematically illustrating a transfer device TDU according to another embodiment.

The transfer device TDU shown in FIG. 17 is substantially the same as the transfer device TDU shown in FIG. 14 except that the first transfer head 210, the second transfer head 220, and the tilting adjustment member 240 are formed or defined by an air gyro AG.

In an embodiment, the air gyro AG may adjust the relative flatness between the stamp 230 and the substrate TS when the buffer member 250 is in contact with the substrate TS. The relative flatness between the stamp 230 and the substrate TS may be adjusted more precisely through the air gyro AG.

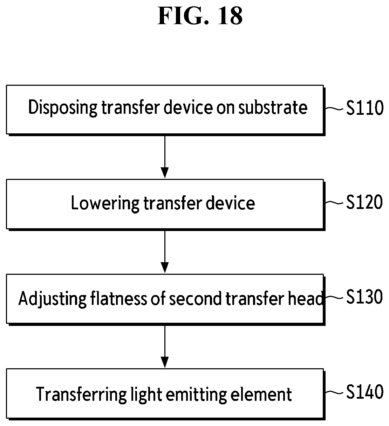

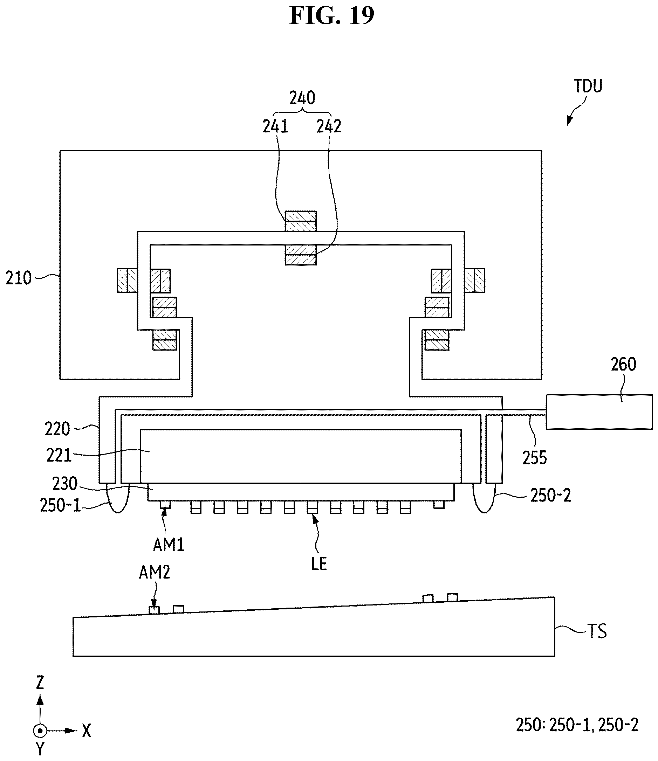

FIG. 18 is a flow chart illustrating a light emitting element transfer method according to an embodiment. FIGS. 19 to 23 are cross-sectional views illustrating an embodiment of a light emitting element transfer method. FIGS. 19 to 23 illustrate cross-sectional views of a structure of a transfer device according to the transfer order of the light emitting element. FIGS. 19 to 23 mainly illustrate a transfer device TDU and a light emitting element LE, which may generally correspond to a cross-sectional view or a plan view of the transfer device TDU described with reference to FIGS. 6 to 10, respectively. In the following, a light emitting element transfer method illustrated in FIGS. 19 to 23 will be described in connection with FIG. 18.

In an embodiment of a light emitting element transfer method, the transfer device TDU is disposed on the substrate TS (S110 in FIG. 18).

Referring to FIG. 19, a light emitting element LE and a first alignment mark AM1 may be attached to the stamp 230 of the transfer device TDU.

A second alignment mark AM2 may be disposed on the substrate TS.

As described above with reference to FIG. 5, the transfer device TDU may be disposed at a desired position by the XY driving unit DU-1 and the Z driving unit DU-2 of the light emitting element transfer device LTD.

In an embodiment, for example, the transfer device TDU may place the stamp 230 on the substrate TS by checking the first alignment mark AM1 and the second alignment mark AM2 disposed on the stamp 230.

In an embodiment of a light emitting element transfer method, the transfer device TDU may be lowered such that the lower surface of the buffer member 250 may contact the substrate TS (S120 in FIG. 18).

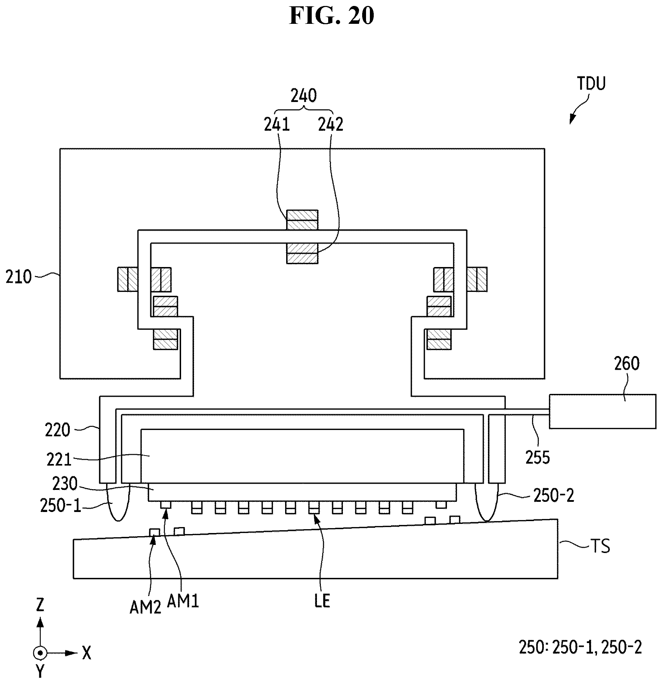

In an embodiment, for example, as shown in FIG. 20, when the transfer device TDU may be lowered and the substrate TS is tilted or bent, some of the buffer members 250-2 may first contact the substrate TS. Then, when the transfer device TDU is lowered further, the remaining buffer members 250-1 may contact the substrate TS.

Before the process of contacting the lower surface of the buffer members 250-1 and 250-2 with the substrate TS, gas is supplied to the buffer members 250-1 and 250-2. Since the thickness of the gas-supplied buffer member 250-1 and 250-2 is thicker than the sum of the thickness of the stamp 230 and the thickness of the light emitting element LE, the light emitting element LE may not contact the substrate TS while the buffer member 250-1 and 250-2 is in contact with the substrate TS.

In an embodiment of a light emitting element transfer method, the flatness of the second transfer head 220 is adjusted to the flatness of the substrate TS by the tilting adjustment member 240 (S130 in FIG. 18).

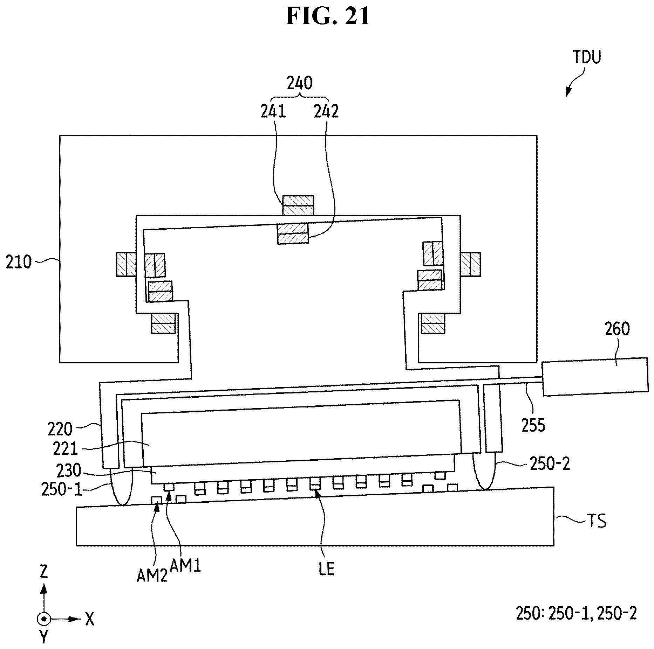

In an embodiment, for example, as shown in FIG. 21, for example, the relative flatness of the second transfer head 220 and the substrate TS may be adjusted while the light emitting element LE is in a non-contact state with the substrate TS. In this way, since the alignment of the light emitting element LE is not disturbed while adjusting the relative flatness of the second transfer head 220 and the substrate TS, high precision of the light emitting element LE may be secured.

In an embodiment of a light emitting element transfer method, the second transfer head 220 is pressed and the light emitting element LE is transferred (S140 in FIG. 18).

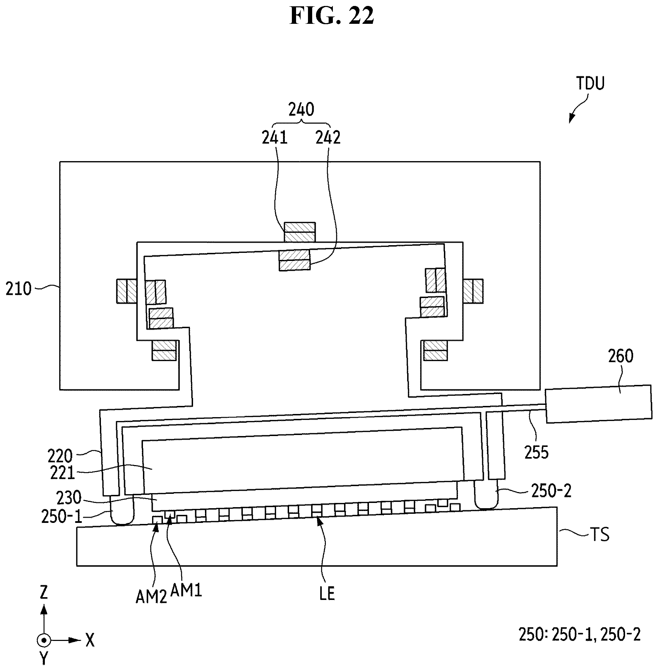

In an embodiment, for example, as shown in FIG. 22, the second transfer head 220 may be lowered further downward to pressurize the buffer member 250 to bring the light emitting element LE into contact with the substrate TS. As the buffer member 250 contracts due to the pressurization, the light emitting element LE may be brought into contact with the substrate TS.

The buffer member 250 may reach a maximum contraction length due to the pressurization and limit the lowering position of the light emitting element LE. The buffer member 250 that has reached the maximum shrinkage length may effectively prevent excessive lowering of the second transfer head 220 by not shrinking any more. The buffer member 250 may shrink to the maximum shrinkage length while pressing and deforming the substrate TS. Since the lowering position is limited by the buffer member 250, the problem of damage to the light emitting element LE may be effectively prevented.

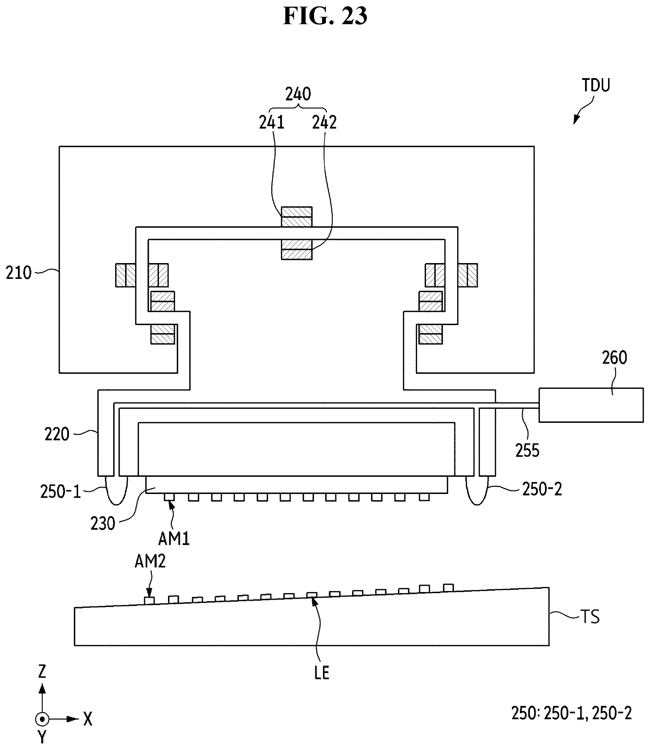

In an embodiment of a light emitting element transfer method, referring to FIG. 23, the transfer device TDU may be lifted to separate the light emitting element LE from the stamp 230.

The display device according to one embodiment of the present disclosure can be applied to various electronic devices. The electronic device according to the one embodiment of the present disclosure includes the display device described above, and may further include modules or devices having additional functions in addition to the display device.

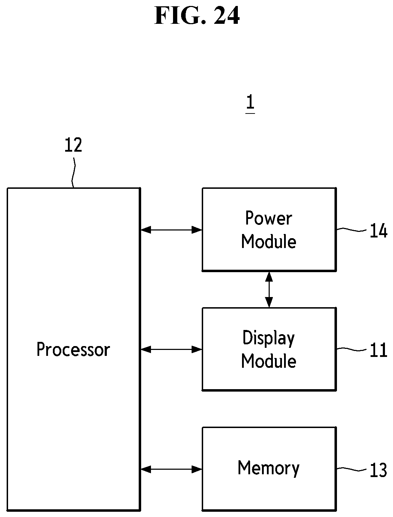

FIG. 24 is a block diagram of an electronic device according to one embodiment of the present disclosure.

Referring to FIG. 24, the electronic device 1 according to one embodiment of the present disclosure may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 15 may store data information necessary for the operation of the processor 12 or the display module 11. When the processor 12 executes an application stored in the memory 15, an image data signal and/or an input control signal is transmitted to the display module 11, and the display module 11 can process the received signal and output image information through a display screen.

The power module 14 may include a power supply module such as, for example a power adapter or a battery, and a power conversion module that converts the power supplied by the power supply module to generate power necessary for the operation of the electronic device 1.

At least one of the components of the electronic device 11 according to the one embodiment of the present disclosure may be included in the display device 10 according to the embodiments of the present disclosure. In addition, some modules of the individual modules functionally included in one module may be included in the display device 10, and other modules may be provided separately from the display device 10. For example, the display device 10 may include the display module 11, and the processor 12, the memory 13, and the power module 14 may be provided in the form of other devices within the electronic device 1 other than the display device 10.

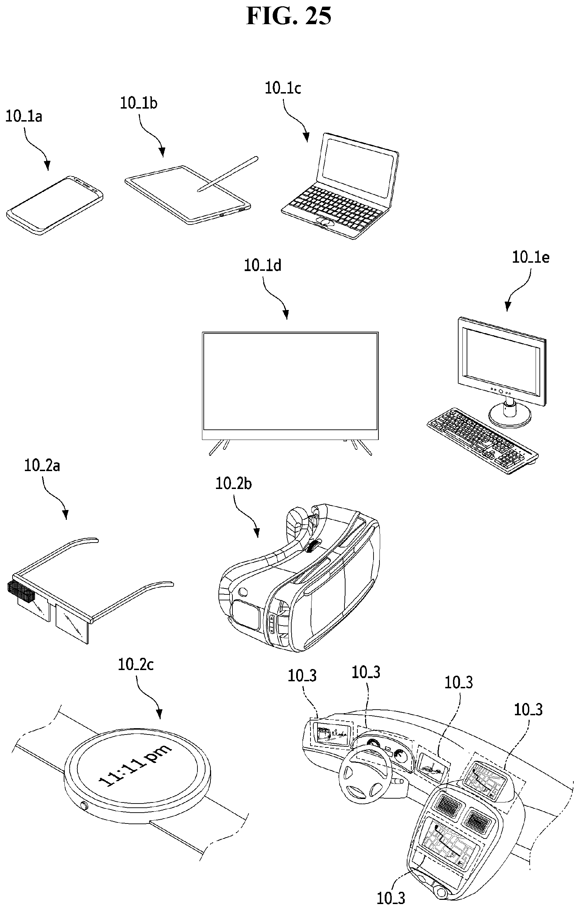

FIG. 25 is a schematic diagram of an electronic device according to various embodiments of the present disclosure.

Referring to FIG. 25, various electronic devices to which display devices 10 according to embodiments of the present disclosure are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

The invention should not be construed as being limited to the embodiments set forth herein. Rather, these embodiments are provided so that this disclosure will be thorough and complete and will fully convey the concept of the invention as defined by the appended claims to those skilled in the art.

While the invention has been particularly shown and described with reference to embodiments thereof, it will be understood by those of ordinary skill in the art that various changes in form and details may be made therein without departing from the scope of the invention as defined by the appended claims.

## Claims

1. A transfer device (TDU) for a light emitting element (LE) comprising:
a first transfer head (210);
a second transfer head (220) disposed below the first transfer head (210);
a stamp (230) disposed below the second transfer head (220);
a tilting adjustment member (240) configured to adjust a tilting of the second transfer head (220); and
a buffer member (250, 250-1, 250-2) disposed below the second transfer head (220) to be adjacent to the stamp (230) and protruding in a downward direction to be lower than the stamp (230), wherein the buffer member (250, 250-1, 250-2) includes an elastic material,
wherein a thickness of the buffer member (250, 250-1, 250-2) is greater than a sum of a thickness of the stamp (230) and a thickness of the light emitting element (LE).

2. The transfer device (TDU) of claim 1, further comprising:
a gas flow path (255) disposed in the second transfer head (220) to supply gas to the buffer member (250, 250-1, 250-2); and
a gas supply member (260) configured to supply gas to the buffer member (250, 250-1, 250-2) through the gas flow path (255).

3. The transfer device (TDU) of claim 1 or 2, wherein the first transfer head (210) defines a cavity with an opening in the downward direction, and a width of the opening is smaller than a width of the cavity.

4. The transfer device (TDU) of claim 3, wherein the second transfer head (220) is divided into a first portion (220-a) disposed in the cavity, a third portion (220-c) disposed outside the first transfer head (210), and a second portion (220-b) disposed between the first portion (220-a) and the third portion (220-c),
wherein a width (Wb) of the second portion (220-b) is narrower than a width (Wa) of the first portion (220-a) and the third portion (220-c).

5. The transfer device (TDU) of claim 4, wherein the tilting adjustment member (240) includes a first permanent magnet (241) disposed on the first transfer head (210), a second permanent magnet (242) disposed on the first portion (220-a) of the second transfer head (220) and facing the first permanent magnet (241) and having a repulsive force with the first permanent magnet (241).

6. The transfer device (TDU) of claim 3, wherein the second transfer head (220) is divided into a first portion (220-a) disposed in the cavity, a third portion (220-c) disposed outside the first transfer head (210), a second portion (220-b) disposed between the first portion (220-a) and the third portion (220-c), and an inclined portion (220-ab) disposed between the first portion (220-a) and the second portion (220-b),
wherein a width of the second portion (220-b) is narrower than a width of the first portion (220-a) and the third portion (220-c).

7. The transfer device (TDU) of claim 6, wherein the tilting adjustment member (240) includes a plurality of second permanent magnets (242) disposed on the first portion (220-a) and the inclined portion (220-ab), and a plurality of first permanent magnets (241) disposed on the first transfer head (210) correspond to the plurality of second permanent magnets (242).

8. The transfer device (TDU) of any one of the preceding claims, further comprising:
a pressure member (270) disposed between the first transfer head (210) and the second transfer head (220) within a cavity of the first transfer head (210), wherein the pressure member (270) presses the second transfer head (220) in the downward direction.

9. The transfer device (TDU) of claim 8,
wherein the pressure member (270) includes a spring; and/or
wherein the pressure member (270) includes an elastic film (271) disposed on the second transfer head (220) within the cavity of the first transfer head (210), a gas pipe (272) connected between the elastic film (271) and the cavity, and a gas supply member (273) configured to supply gas to the gas pipe (272).

10. The transfer device (TDU) of any one of the preceding claims,
wherein the first transfer head (210), the second transfer head (220), and the tilting adjustment member (240) collectively define an air gyro (AG); and/or
wherein the second transfer head (220) includes a chuck (221) on one side and adsorbs a stamp (230) by the chuck (221); and/or
wherein the second transfer head (220) includes a chuck (221) disposed at a lower portion thereof, and the stamp (230) is adsorbed by the chuck (221).

11. The transfer device (TDU) of any one of the preceding claims,
wherein the buffer member (250, 250-1, 250-2) comprises a plurality of buffer members (250, 250-1, 250-2) disposed in a plurality of discontinuous manners around the stamp (230) in a plan view or the buffer members (250, 250-1, 250-2) are disposed continuously around the stamp (230) in a plan view; and/or
wherein the buffer member (250, 250-1, 250-2) includes a diaphragm.

12. A method for transferring a light emitting element (LE), the method comprising:
disposing a transfer device (TDU) including a buffer member (250, 250-1, 250-2) and a stamp (230) on a substrate (SUB);
lowering the transfer device (TDU) to contact a lower surface of the buffer member (250, 250-1, 250-2) with the substrate (SUB), wherein a thickness of the buffer member (250, 250-1, 250-2) is thicker than a sum of a thickness of the stamp (230) and a thickness of a light emitting element (LE);
adjusting a flatness of the transfer device (TDU) to a flatness of the substrate (SUB); and
pressing the buffer member (250, 250-1, 250-2) to contact the substrate (SUB) and to transfer the light emitting element (LE) onto the substrate (SUB), wherein the buffer member (250, 250-1, 250-2) includes an elastic material, and the thickness of the buffer member (250, 250-1, 250-2) becomes thinner when the buffer member (250, 250-1, 250-2) is pressed.

13. The method of claim 12, the disposing the transfer device (TDU) on the substrate (SUB) comprises aligning the light emitting element (LE) disposed on the stamp (230) with the substrate (SUB) based on a first alignment mark (AM1) disposed on one side of the stamp (230) and a second alignment mark (AM2) disposed on the substrate (SUB).

14. The method of claim 12 or 13, wherein the transfer device (TDU) includes a first transfer head (210), a second transfer head (220) disposed below the first transfer head (210), and a tilting adjustment member (240) which adjusts a tilting of the second transfer head (220), and
wherein the adjusting the flatness of the transfer device (TDU) to the flatness of the substrate (SUB) comprises adjusting the tiling of the second transfer head (220) by the tilting adjustment member (240) while the second transfer head (220) is not in contact with the first transfer head (210).

15. The method of any one of claims 12 to 14, wherein the transfer device (TDU) further includes a gas supply member (260) which supplies gas to the buffer member (250, 250-1, 250-2) and a gas flow path (255) connected between the gas supply member (260, 273) and the buffer member (250, 250-1, 250-2),
wherein the method further comprises supplying gas to the buffer member (250, 250-1, 250-2) before the lowering the transfer device (TDU) to contact a lower surface of the buffer member (250, 250-1, 250-2) with the substrate (SUB).
